# EUROPÄISCHE PATENTANMELDUNG

(11) **EP 4 661 607 A1**
(43) Veröffentlichungstag der Anmeldung: **10.12.2025**
(21) Anmeldenummer: 24179761.2
(22) Anmeldetag: 04.06.2024
(51) Int. Cl.: H05K 7/14, H05K 7/20

(54) **AUTOMATISIERUNGSBAUGRUPPE MIT EINEM GEHÄUSE**

(71) Anmelder: Siemens Aktiengesellschaft, 80333 München (DE)
(72) Erfinder: Braeuning, Lydia Rowena, 09120 Chemnitz (DE); Griessbach, Gunter, 09423 Gelenau (DE)
(74) Vertreter: Siemens Patent Attorneys

(57) **Zusammenfassung**

Die Erfindung betrifft eine Automatisierungsbaugruppe (1) mit einem Gehäuse (2), welches eine Rückseite (Ru),
eine Vorderseite (Vo),
eine Unterseite (Un),
eine Oberseite (Ob),
eine linke Seite (Ii) und
eine rechte Seite (re) aufweist,

in dem Gehäuse (2) ist eine Leiterplatte (LP) parallel zwischen der linken Seite (Ii) und der rechten Seite (re) des Gehäuses (2) angeordnet,
die Unterseite (Un) und die Oberseite (Ob) sind zumindest teilweise als ein Lüftungsgitter (LG1.LG2) ausgestaltet, um eine Konvektionskühlung im Inneren des Gehäuses (2) zu ermöglichen, wobei eine Gehäusewand der linken Seite (Ii) und eine Gehäusewand der rechten Seite (re) jeweils eine Abschirmschicht (AS) aufweist, wobei die Abschirmschicht (AS) eine erste Materiallage (M1) und eine zweite Materiallage (M2) aufweist, die erste Materiallage (M1) ist dabei als eine Sperrschicht ausgestaltet, welche eine Wärmestrahlung (30) reflektiert, die zweite Materiallage (M2) ist dabei als eine Durchlassschicht ausgestaltet, welche eine Wärmestrahlung (31) absorbiert und nur teilweise reflektiert,
wobei in den Gehäusewänden die Abschirmschicht (AS) derart angeordnet ist, dass die Sperrschicht in Richtung einer Außenseite des Gehäuses (2) und die Durchlassschicht in Richtung einer Innenseite des Gehäuses angeordnet ist.

## Beschreibung

Die Erfindung betrifft eine Automatisierungsbaugruppe mit einem Gehäuse, welches eine Rückseite, eine Vorderseite,
eine Unterseite, eine Oberseite, eine linke Seite und
eine rechte Seite aufweist, in dem Gehäuse ist eine Leiterplatte parallel zwischen der linken Seite und der rechten Seite des Gehäuses angeordnet, die Unterseite und die Oberseite sind zumindest teilweise als ein Lüftungsgitter ausgestaltet, um eine Konvektionskühlung im Inneren des Gehäuses zu ermöglichen.

In der EP 4 169 361 A1 wird ein Basismodul mit mindestens einem Funktionsmodul vorgestellt. Das Basismodul beinhaltet ein Basisgehäuse mit einem Zirkulationskanal, durch den ein Luftstrom geführt werden kann. Dieser Kanal ist mit Zirkulationsöffnungen versehen, die eine Verbindung zum Inneren des Funktionsgehäuses ermöglichen. Wenn die Kopplungsöffnungen des Funktionsmoduls mit den Zirkulationsöffnungen des Basismoduls verbunden werden, entsteht ein geschlossener Zirkulationskreislauf. In diesem Kreislauf kann der Luftstrom zirkulieren, was einer effizienten und gleichmäßigen Kühlung der

Die in EP 2 285 199 B1 vorgestellte Erfindung betrifft eine modulare Vorrichtung, die eine Lösung für das Problem der Wärmeabfuhr bei elektrischen Baugruppen bietet. Im Gegensatz zu früheren, komplexeren Konstruktionen ermöglicht diese Erfindung eine effiziente Kühlung durch einen einfachen Aufbau. Die Vorrichtung besteht aus einer Tragschiene und mehreren Baugruppen, die darauf montiert sind. Zwischen der Rückwand der Baugruppen und der Tragschiene entsteht ein Raum, der als Kanal für ein Kühlmedium dient. Eine der Baugruppen erzeugt einen Überdruck, der das Kühlmedium durch den Raum und in das Innere der anderen Baugruppen leitet, um diese zu kühlen. Dieses System ist besonders effektiv, da es durch Aneinanderreihung der Baugruppen einen durchgehenden Strömungskanal bildet, der sich über die gesamte Länge der Vorrichtung erstreckt. Dichtelemente an den Enden des Kanals verhindern den Austritt der Kühlluft, wodurch eine optimale Kühlung gewährleistet wird. Die Erfindung zeichnet sich durch geringen konstruktiven Aufwand und hohe Effizienz aus und ist daher eine kostengünstige Lösung für das Wärmemanagement in modularen elektrischen Systemen.

All den aus dem Stand der Technik genannten elektronischen Baugruppen ist gemeinsam, dass durch die Bauteile Verlustleistung generiert wird, die sich durch Wärmeentwicklung bemerkbar macht. Dieser Wärmeentwicklung muss entgegengewirkt werden, damit die Bauteile nicht überlastet werden und in deren Folge die Zuverlässigkeit leidet oder es zum Ausfall kommt. Für die Baugruppen ist eine maximale Umgebungstemperatur festgelegt. Werden die Baugruppen bei der maximalen Umgebungstemperatur betrieben, erhöhen sich die internen Temperaturen der Bauelemente aufgrund ihrer Verlustleistung über diese Umgebungstemperatur hinaus. Es muss darauf geachtet werden, dass die Bauteile dabei thermisch nicht überlastet werden. Das Kriterium dabei ist die Einhaltung der im Datenblatt angegebenen maximalen Chiptemperatur.

Durch entsprechende Maßnahmen werden Vorkehrungen getroffen, dass die Wärme an die Umgebung abgegeben werden kann. Dabei wirken drei physikalische Prinzipien, Wärmeleitung, Konvektion und Wärmestrahlung. Wird die betrachtete Baugruppe in der Nähe von anderen Baugruppen betrieben, die ebenfalls Wärme abgeben, kommt es zu einem zusätzlichen Wärmeeintrag von den betrachteten Baugruppen.

Dabei erfolgt der Ausgleich immer von der wärmeren Seite zur kälteren. Da die Produkte der Automatisierungstechnik hauptsächlich modular aufgebaut sind, werden viele Baugruppen unmittelbar nebeneinander aufgereiht und bilden so ein Automatisierungsgerät.

Für den Fall das bei einem modular aufgebauten Automatisierungsgerät links und rechts einer Baugruppe jeweils eine Baugruppen mit einer hohen einer hohen Verlustleistung betrieben werden, so kann es vorkommen, dass es zur Überhitzung der mittleren Baugruppe kommt. Wenn man dieser möglichen Überhitzung Rechnung tragen wollte, können höhere Kosten für Bauteile mit höherer Temperaturfestigkeit die Folge sein. Höhere Kosten sind ein klarer Wettbewerbsnachteil.

Es ist Aufgabe der vorliegenden Erfindung eine Automatisierungsbaugruppe bereitzustellen, welche trotz Wärme abgebender Nachbarbaugruppen temperaturfest betrieben werden kann, ohne Bauteile mit höherer Temperaturfestigkeit zu verwenden.

Die Aufgabe wird für die Eingangs genannte Baugruppe dadurch gelöst, dass eine Gehäusewand der linken Seite und eine Gehäusewand der rechten Seite jeweils eine Abschirmschicht aufweist, wobei die Abschirmschicht eine erste Materiallage und eine zweite Materiallage aufweist, die erste Materiallage ist dabei als eine Sperrschicht ausgestaltet, welche eine Wärmestrahlung reflektiert, die zweite Materiallage ist dabei als eine Durchlassschicht ausgestaltet, welche eine Wärmestrahlung absorbiert und nur teilweise reflektiert, wobei in den Gehäusewänden die Abschirmschicht derart angeordnet ist, dass die Sperrschicht in Richtung einer Außenseite des Gehäuses und die Durchlassschicht in Richtung einer Innenseite des Gehäuses angeordnet ist.

Die Erfindung präsentiert eine thermische Diode, aufweisend beispielsweise eine Folie mit einem reflektierenden Metall auf einer Seite und einem wärmeabsorbierenden Lack auf der anderen Seite. Die Automatisierungsbaugruppe soll nur mit ihrer eigenen Verlustleistung umgehen, was zu einer kostengünstigeren und flexibleren Produktkonfiguration führt. Im Vergleich zur bekannten Technik verbessert dies die Wärmemanagementeffizienz, ohne dass die Betriebsmodi beschränkt werden müssen oder hitzebeständigere Komponenten notwendig sind.

Die Erfindung stellt somit eine Abschirmschicht für Gehäuse bereit, die Wärmestrahlung von außen reflektiert und Wärmestrahlung von innen absorbiert, während bestehende Technologien auf die Reduktion von Verlustleistung oder den Einsatz temperaturfesterer Bauteile setzen. Durch die Erfindung werden Wärmeübertragungspfade minimiert und Kosten gesenkt, ohne Betriebsmodi zu beschränken oder hitzebeständigere Komponenten zu benötigen.

Eine weitere Ausgestaltung sieht vor, dass die Abschirmschicht als eine beschichtete Folie ausgestaltet ist, welche ein Kernmaterial aufweist, das beidseitig beschichtet ist, eine Seite ist mit einer reflektierenden Metallschicht bedampft, die andere Seite mit ist mit einem Lack versehen, der eine wärmeabsorbierende Wirkung hat.

Als ein Beispiel könnten auf die Gehäusewände zu den Nachbarseiten eine beschichtete Folie aufgebracht werden oder diese Beschichtung wird ins Gehäuse integriert. Beispielsweise ist so die Beschichtung einer Rettungsdecke beschaffen. Bei diesem Material ist der Reflexionsgrad der silbernen Seite mit 0,99 fast ideal. Die goldene Seite (lackiert) hat nur einen Reflexionsgrad von 0,5. Ein Reflexionsfaktor multiplizier mit einem Absorptionsfaktor ergibt gleich den Wert 1, folglich wird die Wärmestrahlung aus Richtung der silbernen Seite fast komplett gesperrt, in Gegenrichtung aber zu 50 % durchgelassen.

Für einen modularen Aufbau aus mehreren Automatisierungsbaugruppen, welche nebeneinander angeordnet sind und über einen Rückwandbus zu Kommunikation untereinander verfügen, wobei die Rückseite ausgestaltet, ist für eine lösbare Montage an einem Baugruppenträger, wird eine weitere Verbesserung dadurch erreicht, dass die Gehäusewand der linken Seite und die Gehäusewand der rechten Seite jeweils ein nach außen gerichtetes Abstandsmittel aufweist. Hierdurch wird erreicht, dass sich die Gehäusewände benachbarter Baugruppen nicht vollflächig berühren können.

Eine spezielle Ausgestaltung sieht vor, dass das Abstandsmittel als ein Steg ausgestaltet ist.

Demnach wird zusätzlich wird ein Steg auf der äußeren Gehäusewand angebracht, um einen direkten Kontakt mit benachbarten Baugruppen zu verhindern und eine Wärmeleitung zu reduzieren. Durch diese Maßnahmen muss jede Baugruppe nur ihre eigene Verlustleistung tolerieren und ist besser gegen Wärmeeinträge von benachbarten Baugruppen geschützt, was die Notwendigkeit teurerer temperaturfester Bauteile reduziert. Zudem wird die Konzeption neuer Produkte durch eine verbesserte Wärmebeherrschung erleichtert und die Wettbewerbsfähigkeit gestärkt.

Abgesehen von Steg selbst befindet sich jetzt zwangsweise immer Luft zwischen den Gehäusewänden. Damit wird die Wärmeleitung von einer Baugruppe erheblich verringert. Die Wärmeleitfähigkeit von Luft ist mit 0,025 gegenüber dem von Kunststoff zwischen 0,25 und 0,5 erheblich geringer.

Eine Modulare Vorrichtung umfassend zumindest eine erste, eine zweite und eine dritte Automatisierungsbaugruppe nach einem der Ansprüche 1 bis 4, kann somit auch bei höheren Umgebungstemperaturen betrieben werden.

Diese Lösung ermöglicht eine kosteneffizientere Gestaltung des Systems, verbessert die Integration neuer Module in bestehende Systeme und trägt zu einer stabilen Gesamtleistung bei. Die spezifischen Verbesserungen, die durch die Erfindung hervorgebracht werden, umfassen eine erhöhte Toleranz der Baugruppen gegenüber externen Wärmequellen und eine daraus resultierende Kostenreduktion für das gesamte System, da keine zusätzlichen Maßnahmen für die Bewältigung der externen Wärmezufuhr erforderlich sind.

Zusammenfassend kann gesagt werden, dass die Erfindung das Problem der effektiven Wärmeabfuhr aus elektronischen Baugruppen durch eine thermische Diode löst, welche Wärmeübertragung unidirektional ermöglicht. Durch den Einsatz reflektierender und absorbierender Schichten in Kombination mit einer baulichen Maßnahme zur Minimierung der Wärmeleitung werden Baugruppen vor Überhitzung geschützt und zusätzliche Kosten für temperaturfestere Bauteile vermieden.

Die Zeichnung zeigt ein Ausführungsbeispiel der Erfindung, dabei zeigt die
- FIG 1: eine Automatisierungsbaugruppe in einer dreidimensionalen Ansicht,
- FIG 2: einen modularen Aufbau nach dem Stand der Technik,
- FIG 3: das Prinzip von Reflexion und Absorption an einer Abschirmschicht,
- FIG 4: einen modularen Aufbau mit den Automatisierungsbaugruppen gemäß der Erfindung und
- FIG 5: den modularen Aufbau mit den Automatisierungsbaugruppen gemäß der Erfindung, wobei die mittlere Automatisierungsbaugruppe aufgeschnitten ist und
- FIG 6: eine Detaildarstellung aus FIG 5.

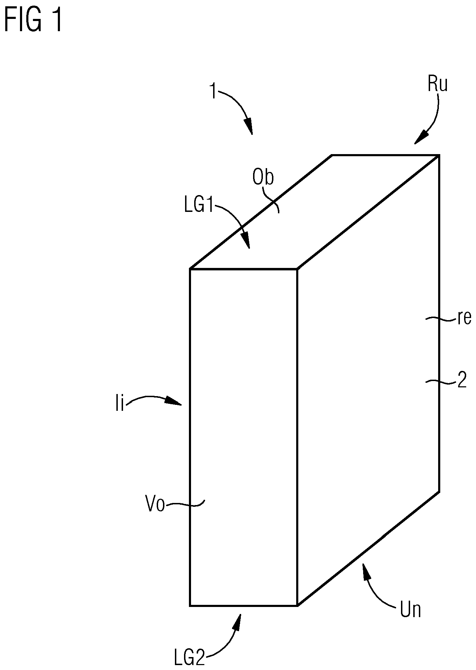

In FIG 1 ist eine Automatisierungsbaugruppe 1 mit einem Gehäuse 2 dargestellt. Das Gehäuse 2 weist eine Rückseite Ru, eine Vorderseite Vo, eine Unterseite Un, eine Oberseite Ob, eine linke Seite li und eine rechte Seite re auf. In dem Gehäuse 2 ist eine erste Leiterplatte LG1 parallel zwischen der linken Seite li und der rechten Seite re des Gehäuses 2 angeordnet. Die Unterseite Un und die Oberseite Ob sind zumindest teilweise als ein erstes Lüftungsgitter LG1 und ein zweites Lüftungsgitter LG2 ausgestaltet, um eine Konvektionskühlung im Inneren des Gehäuses 2 zu ermöglichen.

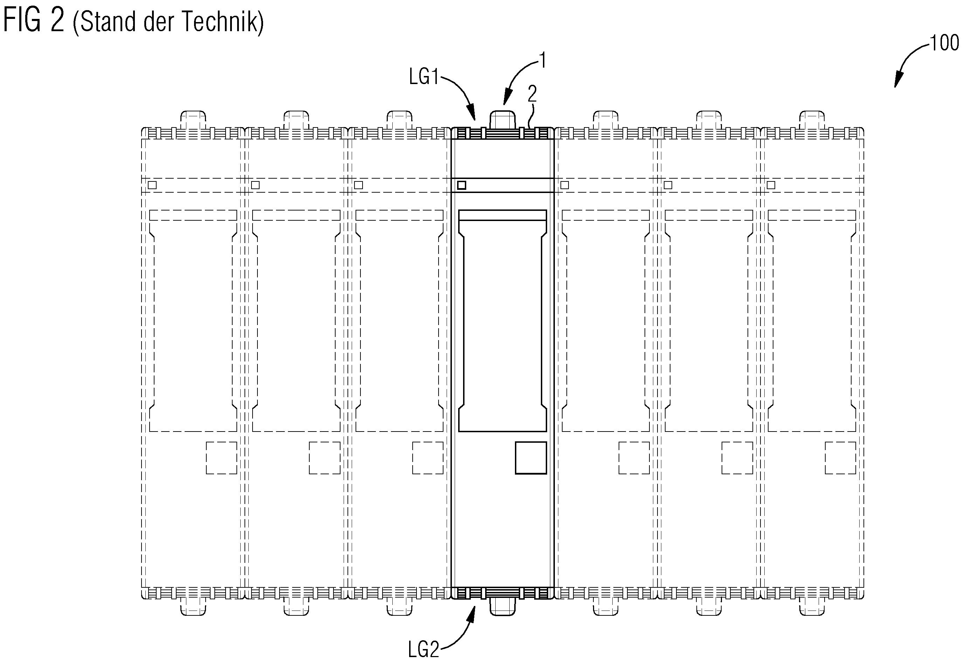

Gemäß FIG 2 ist der Stand der Technik abgebildet. FIG 2 zeigt eine modulare Vorrichtung 100 umfassend mehrere Automatisierungsbaugruppen. Beim Betrieb elektronischer Automatisierungsbaugruppen wird durch Bauteile auf einer Leiterplatte LP eine Verlustleistung generiert, die sich durch Wärmeentwicklung bemerkbar macht. Dieser Wärmeentwicklung muss entgegengewirkt werden, damit die Bauteile nicht überlastet werden und in deren Folge die Zuverlässigkeit leidet oder es zum Ausfall der Automatisierungsbaugruppe kommt. Eine einzelne Automatisierungsbaugruppe 1 kann durch die unten und oben angeordneten Lüftungsgitter LG1,LG2 durch einen Luftstrom bereits entwärmt werden. Dennoch ist für die Automatisierungsbaugruppen eine maximale Umgebungstemperatur festgelegt. Werden die Automatisierungsbaugruppen bei einer maximalen Umgebungstemperatur betrieben, erhöhen sich auch die internen Temperaturen der Bauelemente auf der Leiterplatte LP, aufgrund ihrer Verlustleistung, über diese Umgebungstemperatur hinaus. Es muss darauf geachtet werden, dass die Bauteile dabei nicht thermisch überlastet werden. Das Kriterium dabei ist die Einhaltung einer im Datenblatt angegebenen maximalen Chiptemperatur (junction temperature). Durch entsprechende Maßnahmen werden Vorkehrungen getroffen, dass die Wärme an die Umgebung abgegeben werden kann, insbesondere durch die Lüftungsgitter LG1,LG2. Bei der Wärmeentwicklung wirken drei physikalische Prinzipien, die Wärmeleitung, die Konvektion und die Wärmestrahlung.

Wird wie in der FIG 2 gezeigt die Automatisierungsbaugruppe 1 in der Nähe von anderen Baugruppen betrieben, hier insbesondere in der Mitte von jeweils linksseitig drei angeordneten anderen Automatisierungsbaugruppen und rechtsseitig ebenfalls drei angeordneten Automatisierungsbaugruppen 1, kommt es zu einem zusätzlichen Wärmeeintrag von den benachbarten Automatisierungsbaugruppen in die in der Mitte angeordneten Automatisierungsbaugruppe 1. Dabei erfolgt ein Ausgleich der Wärmestrahlung bzw. Wärmeübertragung immer von einer wärmeren Seite zu einer kälteren Seite. Da die Automatisierungsbaugruppen 1 in der Regel modular aufgebaut werden, also viele Baugruppen unmittelbar nebeneinander aufgereiht werden, bilden so ein Automatisierungsgerät bzw. eine modulare Vorrichtung 100.

Ein sehr ungünstiger Fall könnte auftreten, wenn wie in FIG 2 gezeigt, links und rechts einer zu betrachtenden Automatisierungsbaugruppe 1 jeweils drei Baugruppen mit der höchsten, in einer Produktfamilie vorkommenden Verlustleistung betrieben werden. Bei dieser Art des Betriebes kann es leicht zu einer Überlastung der in der Mitte angeordneten Automatisierungsbaugruppe 1 kommen.

Bisher wurde versucht, die Verlustleistung einer Automatisierungsbaugruppe 1 zu reduzieren, in dem z.B. nicht alle Kanäle eines Moduls gleichzeitig betrieben werden dürfen, es wurde ein sogenanntes Derating eingeführt. Das ist aber eine harte Einschränkung für die Nutzer der Automatisierungsbaugruppen. Alternativ können Temperatur festere Bauteile eingesetzt werden, dies erhöht aber die Kosten.

Die Idee der zugrundeliegenden Erfindung ist es, die betrachtete Automatisierungsbaugruppe 1 besser vor den Einflüssen von Nachbarbaugruppen zu isolieren.

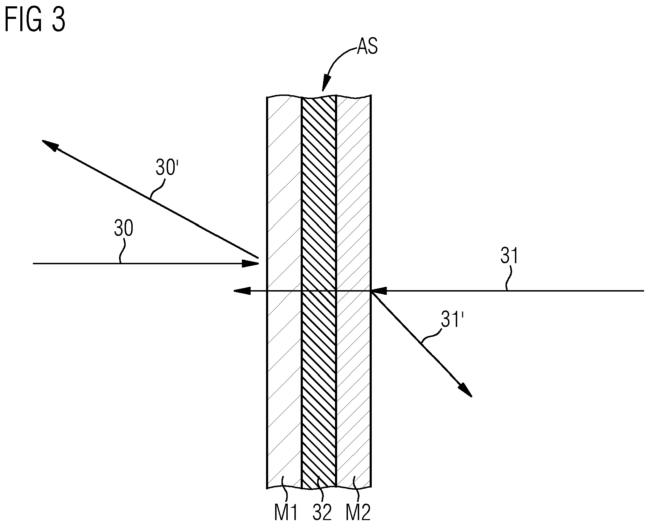

Mit der FIG 3 wird das erfindungsgemäße Prinzip verdeutlicht. In einer Gehäusewand der linken Seite li und in einer Gehäusewand der rechten Seite re ist jeweils eine Abschirmschicht AS angeordnet. Die Abschirmschicht AS weist eine erste Materiallage M1 und eine zweite Materiallage M2 auf, die erste Materiallage M1 ist dabei als eine Sperrschicht ausgestaltet, welche eine Wärmestrahlung 30 reflektiert, die zweite Materiallage M2 ist dabei als eine Durchlassschicht ausgestaltet, welche eine weitere Wärmestrahlung 31 absorbiert und nur teilweise reflektiert. Demnach ist in Gehäusewänden die Abschirmschicht AS derart angeordnet, dass die Sperrschicht in Richtung einer Außenseite des Gehäuses 2 und die Durchlassschicht in Richtung einer Innenseite des Gehäuses 2 angeordnet ist. Wirkt nun eine Wärmestrahlung 30 auf die Automatisierungsbaugruppe 1 so wird diese aufgrund der ersten Materiallage M1 nahezu zu 99% als eine Reflektion 30' der äußeren Wärmestrahlung zurückgeworfen. Im Inneren der Automatisierungsbaugruppe 1 hingegen wird eine innere Wärmestrahlung 31 nahezu zu 50% aufgrund der zweiten Materiallage M2 absorbiert und 50% werden als eine Reflexion 31' der inneren Wärmestrahlung reflektiert.

Die Abschirmschicht AS ist als eine beschichtete Folie ausgestaltet, welche ein Kernmaterial 32 aufweist, dieses Kernmaterial 32 ist beidseitig beschichtet. Demnach ist eine Seite mit einer reflektierenden Metallschicht bedampft und die andere Seite ist mit einem Lack versehen, der eine wärmeabsorbierende Wirkung hat. Das Verhalten entspricht dem einer Diode in der Elektronik. Eine Folie/Grenzschicht als Abschirmschicht AS kann als eine thermische Diode betrachtet werden. Durch eine geeignete Beschichtung auf der durchlässigen Seite sind erheblich höhere Absorptionsgrade zu erreichen. Die Eigenschaften der thermischen Diode werden damit erheblich verbessert.

Das mit FIG 3 gezeigte Prinzip wirkt sich erheblich auf einen Wärmestrahlungseintrag in einer Automatisierungsbaugruppe 1 aus. Denn, wird die stark reflektierende Seite nach außen gerichtet, können die Wärmeeinträge von Nachbarbaugruppen drastisch eingeschränkt werden.

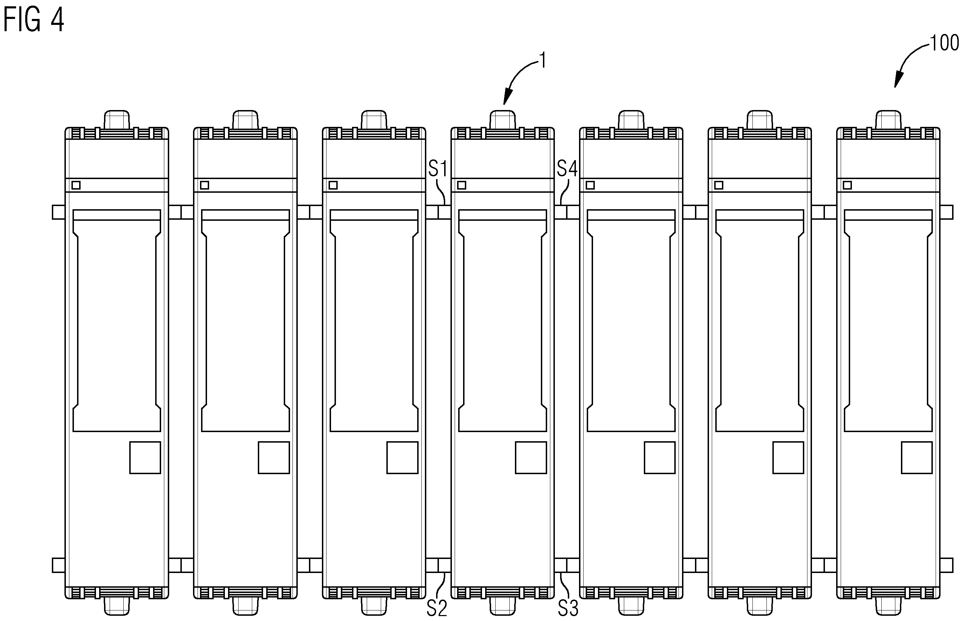

Mit der FIG 4 wird eine Kombination aus der Ausgestaltung mit der Abschirmschicht AS und einem zusätzlich eingeführten Abstandsmittel aufgezeigt. Da die Automatisierungsbaugruppe 1 für einen modularen Aufbau aus mehreren Automatisierungsbaugruppen 1, welche nebeneinander angeordnet sind, ausgestaltet ist, und diese über einen Rückwandbus zur Kommunikation untereinander kommunizieren können, ist die Rückseite ru in der Regel ausgestaltet, für eine lösbare Montage an einem Baugruppenträger. Zusätzlich zur Abschirmschicht weist nun die Gehäusewand der linken Seite li und die Gehäusewand der rechten Seite re jeweils ein nach außen gerichtetes Abstandsmittel auf. Das Abstandsmittel ist ausgestaltet, als ein erster Steg S1, ein zweiter Steg S2, ein dritter Steg S3 und ein vierter Steg S4.

Mit dieser Kombination beider Methoden, nämlich Abschirmschicht AS und Abstandsmittel, wird erreicht, dass die Automatisierungsbaugruppen nur mit ihrer eigenen Verlustleistung zurechtkommen müssen und nicht zusätzlich durch besonders wärmeentwickelnden Nachbarn aufgeheizt werden.

Die Wärmeleitung und die Wärmestrahlung haben bei der Wärmeabgabe von elektronischen Baugruppen einen erheblichen Anteil. Zusammen mit der Konvektion ergeben sich etwa jeweils ein Drittel für jede Übertragungsart. Werden die Automatisierungsbaugruppen 1 wie vorgeschlagen ausgestaltet, wird das Problem des Fremdeintrages von Wärmestrahlung 30 aus benachbarten Baugruppen erheblich abgemildert. Durch dieses Gegensteuern werden die folgenden Vorteile wirksam:
- Unnötige Zusatzkosten für temperaturfeste Bauteile werden vermieden,
- ein modulares System kann so ausgestaltet werden, dass die gegenseitigen Beeinflussungen herabgesetzt sind und ist in Summe in wärmebelasteten Umgebungen flexibler einzusetzen,
- neue Automatisierungsbaugruppen lassen sich leichter in bestehende Systeme integrieren, das Systemverhalten ist stabiler und weniger abhängig von der Anordnung der Automatisierungsbaugruppe in der modularen Vorrichtung 100.

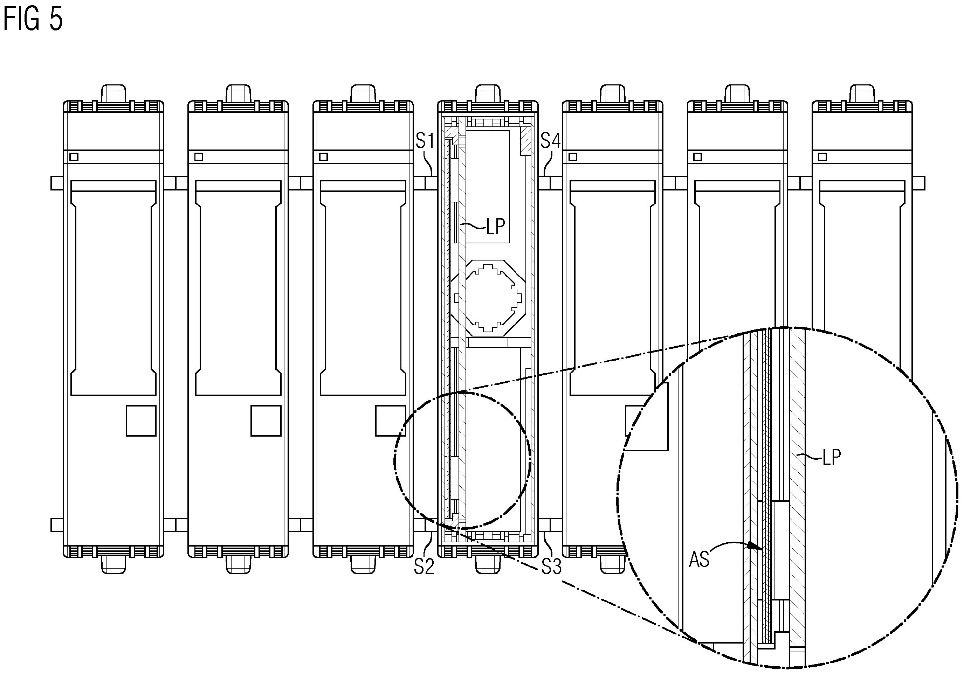

Die FIG 5 zeigt noch einmal die in FIG 4 dargestellte modulare Vorrichtung 100 mit den Automatisierungsbaugruppen 1. Die in der Mitte angeordnete Automatisierungsbaugruppe 1 ist nun in einer aufgeschnittenen Darstellung abgebildet. Der Blick auf die Leiterplatte LP, auf welcher die wärmeabgebenden Bauteile angeordnet sind, wird deutlich. In der Gehäusewand ist das Abschirmmittel AS angeordnet.

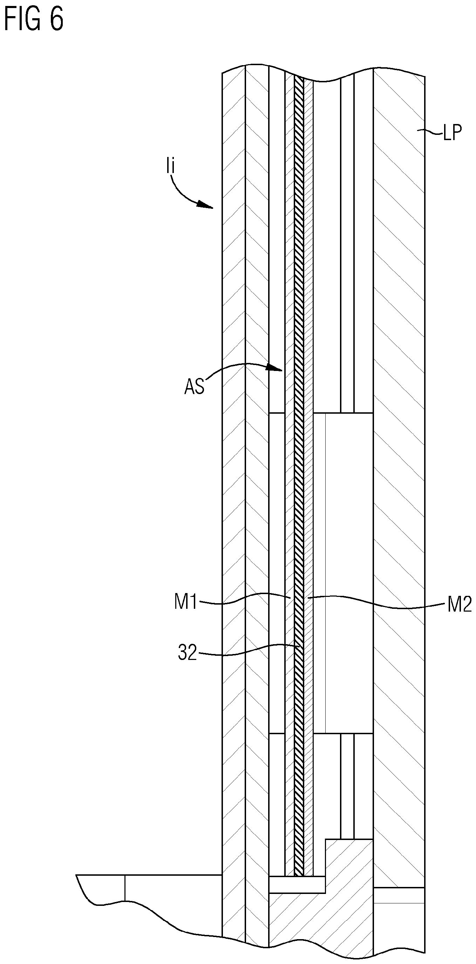

Die FIG 6 zeigt die Detaildarstellung aus FIG 5. In der Gehäusewand der linken Seite li ist das Abschirmmittel AS mit dem Kernmaterial 32 angeordnet. Die Abschirmschicht AS weist zur linken Seite li die erste Materiallage M1 und zur rechten Seite die zweite Materiallage M2 auf.

## Patentansprüche

1. Automatisierungsbaugruppe (1) mit einem Gehäuse (2), welches eine Rückseite (Ru),
eine Vorderseite (Vo),
eine Unterseite (Un),
eine Oberseite (Ob),
eine linke Seite (li) und
eine rechte Seite (re) aufweist,
in dem Gehäuse (2) ist eine Leiterplatte (LP) parallel zwischen der linken Seite (li) und der rechten Seite (re) des Gehäuses (2) angeordnet,
die Unterseite (Un) und die Oberseite (Ob) sind zumindest teilweise als ein Lüftungsgitter (LG1,LG2) ausgestaltet, um eine Konvektionskühlung im Inneren des Gehäuses (2) zu ermöglichen,
**dadurch gekennzeichnet, dass**
eine Gehäusewand der linken Seite (li) und eine Gehäusewand der rechten Seite (re) jeweils eine Abschirmschicht (AS) aufweist, wobei die Abschirmschicht (AS) eine erste Materiallage (M1) und eine zweite Materiallage (M2) aufweist, die erste Materiallage (M1) ist dabei als eine Sperrschicht ausgestaltet, welche eine Wärmestrahlung (30) reflektiert, die zweite Materiallage (M2) ist dabei als eine Durchlassschicht ausgestaltet, welche eine Wärmestrahlung (31) absorbiert und nur teilweise reflektiert,
wobei in den Gehäusewänden die Abschirmschicht (AS) derart angeordnet ist, dass die Sperrschicht in Richtung einer Außenseite des Gehäuses (2) und die Durchlassschicht in Richtung einer Innenseite des Gehäuses angeordnet ist.

2. Automatisierungsbaugruppe (1) nach Anspruch 1,
wobei die Abschirmschicht (AS) als eine beschichtete Folie ausgestaltet ist, welche ein Kernmaterial (32) aufweist, das beidseitig beschichtet ist, eine Seite ist mit einer reflektierenden Metallschicht bedampft, die andere Seite mit ist mit einem Lack versehen, der eine wärmeabsorbierende Wirkung hat.

3. Automatisierungsbaugruppe (1) nach Anspruch 1 oder 2,
ausgestaltet für einen modularen Aufbau aus mehreren Automatisierungsbaugruppen, welche nebeneinander angeordnet sind und über einen Rückwandbus zu Kommunikation untereinander verfügen, wobei die Rückseite (Ru) ausgestaltet ist für eine lösbare Montage an einem Baugruppenträger, **dadurch gekennzeichnet** das, die Gehäusewand der linken Seite (li) und die Gehäusewand der rechten Seite (re) jeweils ein nach außen gerichtetes Abstandsmittel aufweist.

4. Automatisierungsbaugruppe (1) nach Anspruch 3, wobei das Abstandsmittel als ein Steg (S1,S2,S3,S4) ausgestaltet ist.

5. Modulare Vorrichtung (100) umfassend zumindest eine erste, eine zweite und eine dritte Automatisierungsbaugruppe (1) nach einem der Ansprüche 1 bis 4.
